## Europäisches Patentamt
## European Patent Office
## Office européen des brevets

(19)

(11) Numéro de publication: **0 030 280**
**B1**

(12) **FASCICULE DE BREVET EUROPEEN**

(45) Date de publication du fascicule du brevet: **30.11.83**

(21) Numéro de dépôt: **80107021.0**

(22) Date de dépôt: **14.11.80**

(51) Int. Cl.³: **H 01 L 27/10,**
**H 01 L 23/52,**
**G 11 C 17/00, H 03 K 19/02**

(54) Réseau matriciel d'éléments semi-conducteurs.

(30) Priorité: **07.12.79 FR 7930421**

(43) Date de publication de la demande:
**17.06.81 Bulletin 81/24**

(45) Mention de la délivrance du brevet:
**30.11.83 Bulletin 83/48**

(84) Etats contractants désignés:
**DE FR GB**

(73) Titulaire: **International Business Machines**
**Corporation**
**Old Orchard Road**
**Armonk, N.Y. 10504 (US)**

(72) Inventeur: **Bauge, Michel Georges Françis**
**18 Boulevard de la Faisanderie**
**F-77330 Lesigny (FR)**
Inventeur: **Mollier, Pierre Bernard**
**15 rue de Ponthierry**
**F-77310 Boissise le Roi (FR)**

(74) Mandataire: **Lattard, Nicole**
**COMPAGNIE IBM FRANCE Département de**
**Propriété Industrielle**
**F-06610 La Gaude (FR)**

(56) Documents cités:
FR - A - 2 088 515
FR - A - 2 296 967

IEEE JOURNAL OF SOLID STATE CIRCUITS, vol.
SC-5, no. 5, octobre 1970 New York US J.C.
BARRETT et al.: "Design considerations for a
high speed bipolar-read-only memory", pages
196-202
IBM TECHNICAL DISCLOSURE BULLETIN vol.
19, no. 9, février 1977 New York US J.J.
HESSION et al.: "Diffused shorting bar for
integrated diode string", pages 3492-3494

Courier Press, Leamington Spa, England.

Réseau matriciel d'éléments semi-conducteurs

### Domaine Technique

La présente invention concerne les réseaux d'éléments semi-conducteurs, diodes de Schottky ou transistors intégrés dans des microplaquettes dans lesquels les éléments sont disposés suivant une matrice et qui sont personnalisés pour réaliser une fonction donnée, par exemple, matrice ET ou matrice OU dans des réseaux logiques programmables PLA ou mémoires mortes, ayant des caractéristiques de densité et de dissipation de puissance améliorées.

### Etat de la Technique Antérieure Les réseaux en matrice d'éléments semi-conducteurs constituant des mémoires mortes ou les réseaux ET ou OU d'un réseau logique programmable (PLA) sont aujourd'hui bien connus et couramment utilisés. On pourra notamment se référer au brevet français No. 71 16554 qui décrit une mémoire morte comprenant comme éléments d'emmagasinage des diodes de Schottky dans laquelle les diodes d'une même colonne sont situées dans une poche de substance semi-conductrice constituant les cathodes des diodes, la liaison entre les cathodes étant assurée par une couche enrobée. Des parois isolantes sont prévues entre les rangées de diodes. Dans une telle mémoire, un bit d'information est représenté par la présence ou l'absence de diodes.

Un tel arrangement présente l'avantage d'une densité accrue par rapport aux arrangements classiques dans lesquelles chaque diode est dans une poche d'isolation, mais étant donné que la couche enrobée a une résistivité qui bien que faible n'est pas négligeable, on ne peut envisager de réaliser des réseaux de très grande densité.

Les réseaux logiques programmables sont généralement constitués d'une matrice ET et d'une matrice OU qui sont personnalisées pour réaliser une fonction donnée. Pour avoir une description générale des réseaux logiques programmables, on pourra se référer à l'ouvrage de MM. William N. Carr et Jack P. Mize, intitulé "MOS/LSI and Application" édité par McGraw Hill Book Company dans la série Texas Instruments Electronics. Les matrices ET et OU sont constituées dans des microplaquettes qui sont personnalisées en disposant ou non un élément semi-conducteur diode de Schottky ou transistor aux différentes positions des matrices suivant la fonction que doit réaliser le réseau PLA. En conséquence, lorsqu'on veut utiliser un réseau PLA, il faut d'abord déterminer quels doivent être les contenus des différentes matrices et ensuite personnaliser les microplaquettes. En fait, cette étape de personnalisation est identique à l'étape de l'inscription des informations dans une mémoire morte, et en conséquence les réseaux ET ou OU présentent les mêmes structures que les mémoires mortes et peuvent être réalisés suivant les mêmes techniques notamment celles du brevet précité.

### Objet de l'Invention

La présente invention a donc pour objet de réaliser des réseaux d'éléments semi-conducteurs pouvant être utilisés comme mémoires mortes ou pour constituer des réseaux logiques programmables ayant des densités élevées sans que cela nuise aux performances.

### Résumé de l'Invention

La présente invention est applicable à tout type de réseau constitué en matrice intégrée d'éléments semi-conducteurs par exemple diodes de Schottky ayant des électrodes anode ou cathode, ou transistors ayant des électrodes à savoir:base, émetteur ou collecteur et personnalisé en disposant ou non un élément en chaque position de la matrice.

Les positions de la matrice sont définis aux intersections de deux séries de lignes, les lignes de la première série étant perpendiculaires aux lignes de la seconde série. Lorsqu'une diode de Schottky est présente en une position, son anode est connectée à la ligne correspondante dans la première série et sa cathode est connectée à la ligne correspondante dans la deuxième série. Dans un tel réseau à diodes de Schottky, les diodes d'une même colonne sont réalisées dans au moins un lit épitaxial, la couche de sous-collecteur servant de seconde ligne de connexion. Les éléments d'une colonne sont isolés des éléments des colonnes adjacentes par des parois d'isolation s'étendant jusqu'au substrat.

Pour réaliser la personnalisation, dans chaque colonne la configuration de chaque groupe de 2k positions successives est analysée en partant du point milieu du groupe, et pour les k positions dans la partie supérieure, le lit épitaxial n'est réalisé qu'à partir de la première position rencontrée occupée par une diode jusqu'à la position extrême supérieure et il en est de même pour les k positions dans la partie inférieure, pour lesquelles le lit épitaxial n'est réalisé qu'à partir de la première position rencontrée occupée par une diode jusqu'à la position extrême inférieure.

La personnalisation du réseau implique ensuite la mise en place des contacts anodes dans les positions de la matrice contenant une diode. Les premières lignes sont disposées au premier niveau de métallisation et relient toutes les anodes des diodes d'une même rangée.

Entre les positions adjacentes de deux groupes contigus sont prévus un trou de connexion et un contact qui permettront de réaliser le court-circuit des positions de chaque groupe, au second niveau de métallisation.

Lorsque les éléments semi-conducteurs de réseau sont des transistors, le même procédé est utilisé, les lits communs dopés P (dans le cas de transistors NPN) constituant les régions bases, dans lesquelles sont diffusées les régions émetteurs des transistors présents dans le réseau.

D'autres objets, caractéristiques et avantages de la présente invention ressortiront mieux de l'exposé qui suit, fait en référence aux dessins annexés à ce texte, qui représentent deux modes de réalisation préférés de celle-ci.

Brève Description des Figures

La figure 1 représente schématiquement un réseau de diodes de Schottky qui peut être intégré conformément à la présente invention.

La figure 2 représente une veu de dessus d'une partie de réseau de la figure 1 montrant le principe de la présente invention.

La figure 3 représente une vue en coupe le long de la ligne A—A' de la figure 2.

La figure 4 représente une vue en coupe le long de la ligne B—B' de la figure 2.

La figure 5 représente schématiquement un réseau de transistors pouvant être intégré conformément à la présente invention.

La figure 6 représente une vue de dessus du réseau de la figure 5.

La figure 7 représente une vue en coupe le long de la ligne C—C' de la figure 6.

La figure 8 représente une vue en coupe le long de la ligne D—D' de la figure 6.

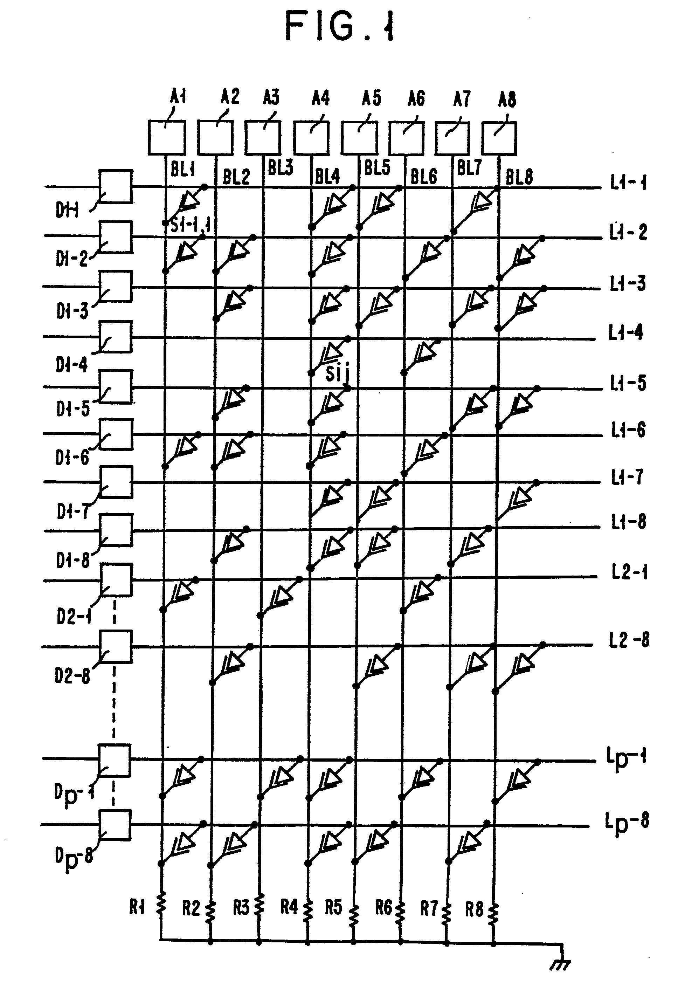

Sur la figure 1, est représenté un réseau de diodes de Schottky qui peut être utilisé comme mémoire morte ou comme matrice OU dans un réseau logique programmable.

Les positions de la matrice sont définies aux points d'intersection de lignes de mots horizontales L1—1 à L1—8, L2—1 à L2—8, ..., Lp—1 à Lp—8 et de lignes de sortie verticales BL—1 à BL—8. Les lignes de mots sont attaquées par des circuits de commande D1—1 à D1—8, D2—1 à D2—8, ..., Dp—1 à Dp—8 qui permettent d'établir sur les lignes de mots les niveaux de signaux appropriés pour sélectionner ou non une ligne. Les lignes de sortie sont d'une part connectées à la masse par l'intermédiaire de résistances R1 à R8 et d'autre part à des circuits de détection A1 à A8. Toutes les diodes de Schottky n'ont pas été référencées sur le dessin pour plus de clarté. Pour une diode quelconque Sij du réseau, i représente la ligne de mot à laquelle est connectée son anode et j la ligne de sortie à laquelle est connectée sa cathode.

Des diodes Sij sont placées en certaines positions de la matrice suivant une configuration donnée qui dépend de la fonction réalisée par le réseau.

Le fonctionnement d'un tel réseau ne sera pas décrit car ce n'est pas l'objet de l'invention. Lorsque le réseau est utilisé comme mémoire morte, l'excitation d'une ligne de mot particulière provoque la lecture des informations contenues dans cette ligne, en supposant que la ligne L1—5 soit sélectionnée, les circuits A1 à A8 détecteront l'état du mot correspondant, à savoir, 01010011.

Lorsque ce réseau est utilisé comme matrice OU d'un réseau logique programmable, les circuits d'attaque D1—1 à Dp—8 reçoivent les signaux de sortie de la matrice ET du réseau, et les diodes de Schottky de chaque colonne effectuent l'opération OU des signaux logiques amenés aux circuits d'attaque auxquels elles sont connectées.

Conformément à l'invention, les lignes de mots sont réparties en p groupes de 2k lignes, k étant égal à 4 sur le dessin, les lignes du premier groupe sont toutes représentées et portent les références L1—1 à L1—8, tandis que les lignes des groupes suivants qui ne sont pas toutes représentées portent les références L2—1 à L2—8, ..., Lp—1 à Lp—8.

Le même principe peut s'appliquer à une matrice à diodes Schottky organisée en circuits ET dans un réseau PLA, dans ce cas les rôles des lignes sont inversés à savoir les entrées s'effectuent sur les cathodes et les sorties sur les anodes.

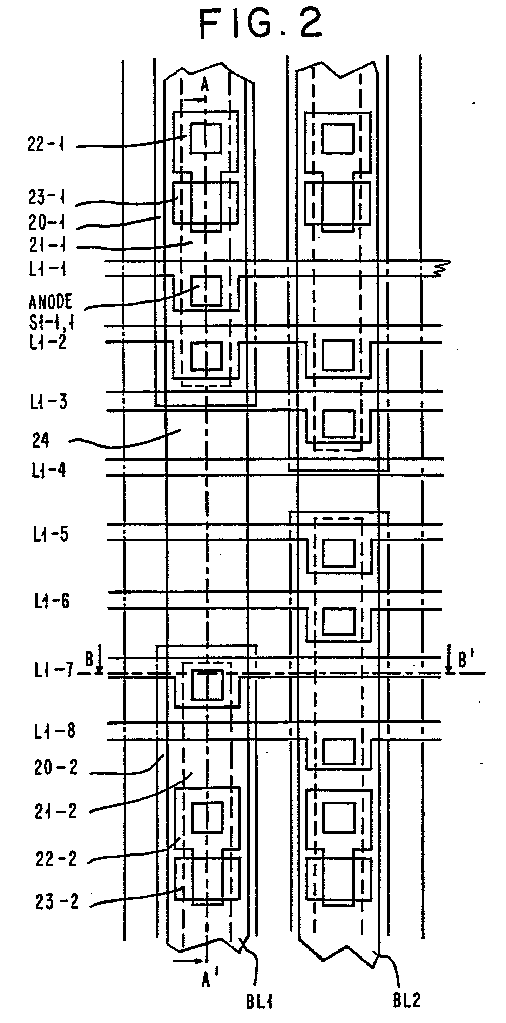

En référence aux figures 2, 3 et 4 on va décrire la structure du réseau conformément à l'invention. Sur cette figure, on n'a représenté que les diodes des deux premières colonnes du premier groupe, étant bien entendu que cette structure est la même pour les autres colonnes et les autres groupes.

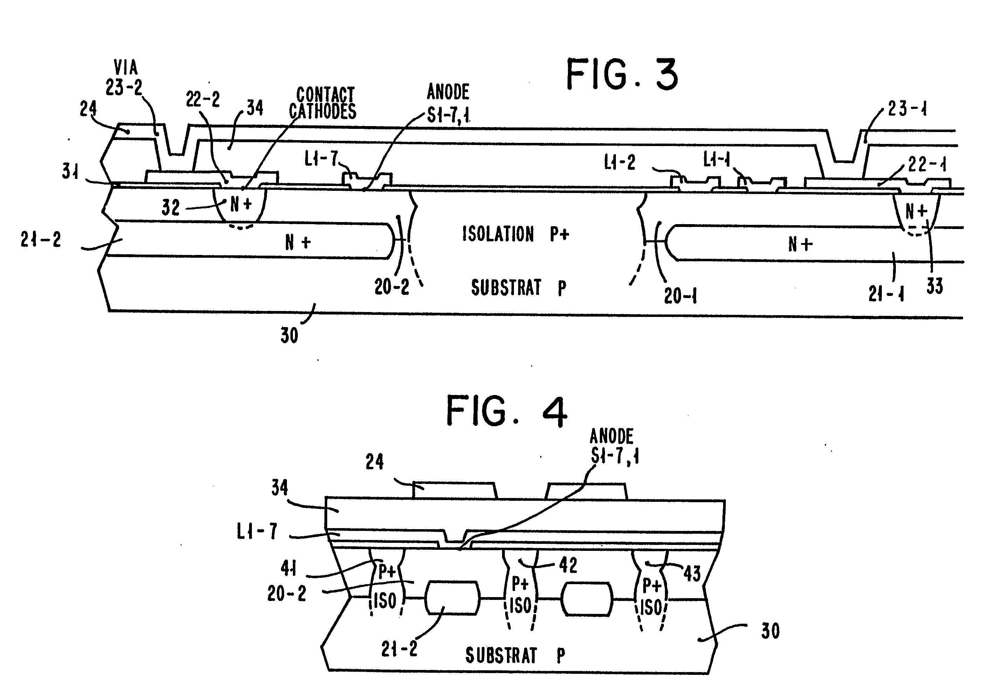

Sur la figure 2, on peut voir les lignes de mont L1—1 à L1—8 situées au premier niveau de métallisation. Les diodes présentes dans le réseau sont représentées par le contact anode, sur la figure le contact anode de la diode S1—1, 1 a été référencé et ou pourra très facilement repérer les autres contacts anodes des diodes présentes dans le réseau. Les colonnes de diodes sont isolées par des parois d'isolation qui sont visibles sur les vues en coupe le long des lignes A—A' et B—B', sur les figures 3 et 4 respectivement. Conformément à l'invention, le lit épitaxial 20 et la région sous-collecteur 21 correspondant aux cathodes des diodes d'une colonne, ne sont pas continus. Dans une colonne, en partant du milieu de chaque groupe, par exemple entre les lignes L1—4 et L1—5, on ne réalise les couches épitaxiales et régions sous-collecteur qu'à partir des premières positions rencontrées occupées par une diode jusqu'aux extrémités du groupe. Ainsi pour la colonne de gauche sur la figure 2, les couches 20 et 21 se divisent en régions 20—1 et 20—2 et 21—1 et 21—2 séparées par de l'isolation.

A chaque extrémité du groupe de diodes, se trouve un ensemble contact cathode de Schottky, 22—1 en haut, 22—2 en bas, au premier niveau de métallisation et un trou de connexion ou via 23—1 en haut, 23—2 en bas, permettant de faire la liaison électrique entre le premier et le second niveaux de métallisation.

Les cathodes des diodes de la première colonne sont reliées par les régions 21—1 et 21—2, afin d'assurer la continuité électrique et de diminuer la résistance série de la ligne verticale qui est la ligne de sortie pour un réseau du type représenté sur la figure 1, un court-circuit 24 est prévu au deuxième niveau de métallisation entre les deux contacts de cathode 22—1 et 22—2 par l'intermédiaire des trous de connexion 23—1 et 23—2. Cet arrangement sera plus facilement visible sur la figure 3.

La figure 3 représente une coupe le long de la ligne A—A'. L'ensemble est intégré dans un substrat 30 de conductivité de type P par exemple. On peut voir les deux parties de la couche épitaxiale, 20—2 et 20—1 et les régions sous-collecteurs 21—2 et 21—1.

Une couche d'oxyde 31 est disposée au-dessus de l'ensemble semi-conducteur dans laquelle sont prévues des ouvertures pour établir les contacts anode et cathode comme on peut le voir en L1—7, L1—2 et L1—1 et 22—2, 21—1, situés au premier niveau de métal. Deux zones N+ 32 et 33 sont situées au-dessous des parties 22—2 et 22—1 jusqu'à la couche de sous-collecteur pour achever les diodes de Schottky.

Une couche de quartz 34 constitue l'isolation entre les deux niveaux de métallisation, le court-circuit 24, au second niveau de métallisation permet de faire la liaison entre les contacts cathodes extrêmes du groupe.

La figure 4 représente la coupe de la structure le long de la ligne B—B' de la figure 2. Sur cette coupe on peut voir les régions d'isolation P+ 41, 42, 43 qui isolent les diodes de chaque colonne. De même au premier niveau de métallisation on voit la ligne L1—7 avec un contact anode pour réaliser la diode S1—7 et sans contact anode dans la deuxième colonne dans laquelle il ne se trouve pas de diode.

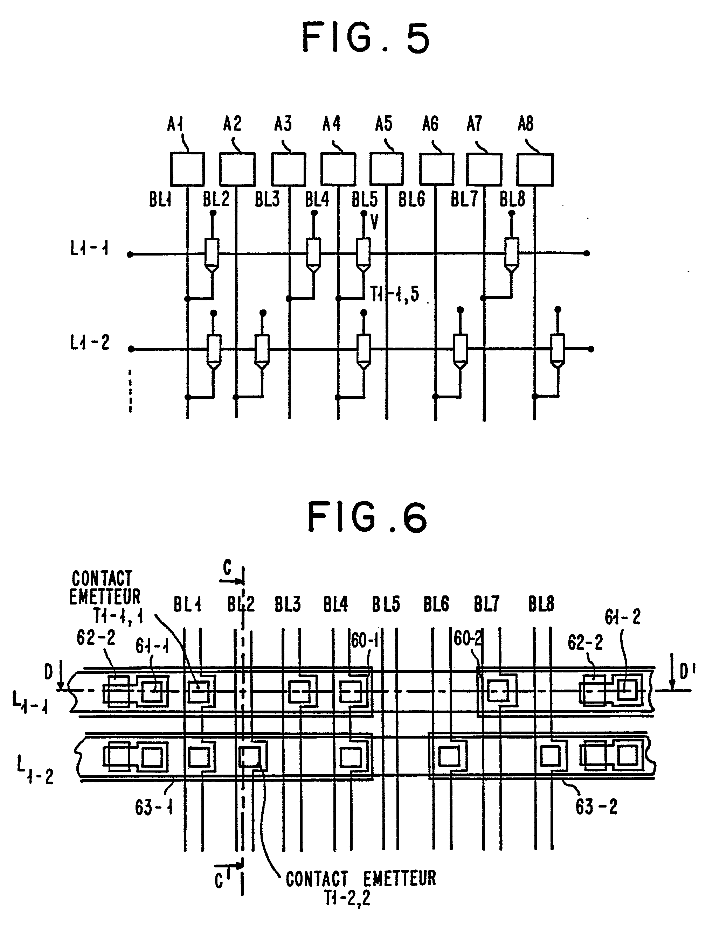

Sur la figure 5 est représentée une matrice OU dans un réseau logique programmable dans laquelle des diodes de Schottky ont été remplacées par des transistors de type NPN sur le dessin. On n'a représenté que deux lignes L1—1 et L2—2 et huit lignes BL—1 à BL—8 reliées aux circuits A1 à A8 comme sur la figure 1.

Les diodes sont remplacées par des transistors Tij, i représentant le numéro de ligne de mots et j le numéro de ligne de bits. La base du transistor Tij est connectée à la ligne Li, l'émetteur est connecté à la ligne BLj, le collecteur est connecté à une tension de polarisation V.

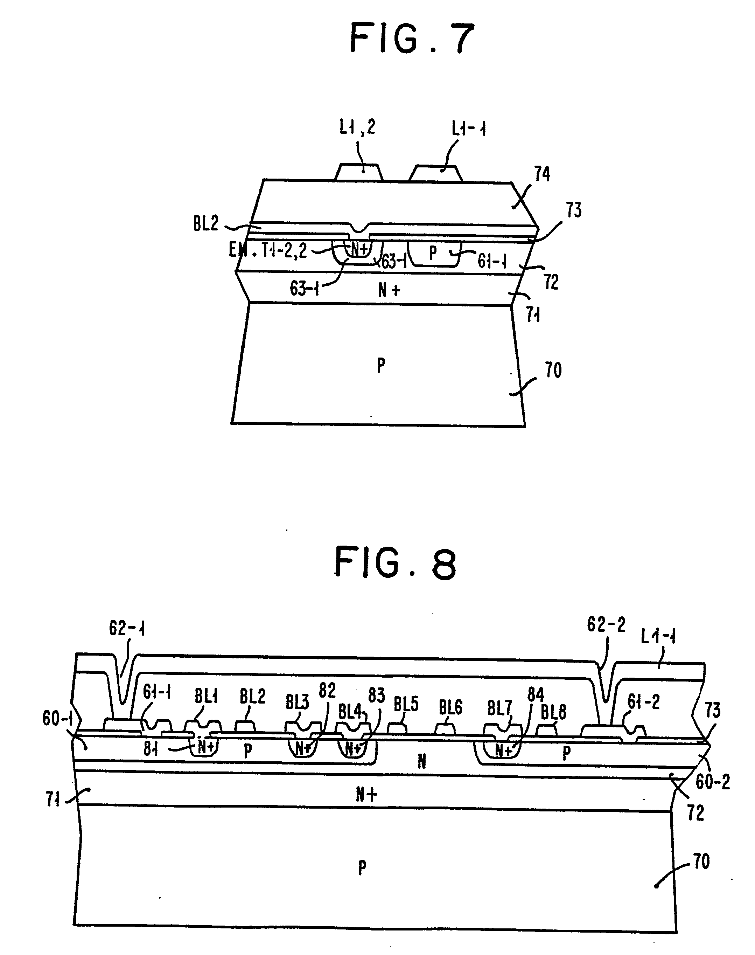

En référence aux figures 6, 7 et 8 qui représentent une vue de dessus et des vues en coupe on va montrer comment sont intégrés les transistors conformément à l'invention. Comme on peut le voir sur les figures 7 et 8, l'ensemble est intégré dans un substrat de type P, 70. La vue de dessus de la structure sur la figure 6 montre les lignes de bits BL—1 à BL—8 avec les contacts émetteurs présents ou non, suivant qu'il y a ou non un transistor dans la position correspondante, le contact émetteur de T1—2, 2 a été référencé.

La figure 7 représente une vue en coupe suivant la ligne C—C' de la figure 6 et la figure 8 représente une vue en coupe suivant la ligne D—D'. Pour mettre en oeuvre le principe de la présente invention, les huit éléments, connectés à une ligne L1—1 constituent un groupe, les éléments connectés aux autres lignes Li constituant les autres groupes. Il est bien entendu que puisqu'il n'y a que huit éléments dans le sens horizontal, il n'y aura qu'un groupe par ligne Li mais si le nombre d'éléments était supérieur, il pourrait y avoir plusieurs groupes par lignes Li.

Au-dessus du substrat se trouve une région sous-collecteur 71 de type N+ et une région épitaxiale N 72 constituant la région collecteur commune à tous les transistors du groupe. Au-dessus de la structure semi-conductrice se trouve une couche d'oxyde 73 à travers laquelle sont réalisés les différents contacts et une couche de quartz 74 qui constitue l'isolation entre les deux niveaux de métal.

Conformément à la présente invention on ne réalise des diffusions bases dans chaque groupe de part et d'autre du point milieu du groupe, qu'à partir de la première position rencontrée occupée par un transistor, c'est ainsi que pour la première ligne d'éléments il y a deux diffusions bases 60—1 et 60—2. De même pour la ligne L1—2 il y a deux diffusions bases 63—1 et 63—2. A chaque extrémité du premier groupe se trouve un ensemble contact base 61—1 et 61—2, trou de connexion 62—1, 62—2. Les mêmes ensembles sont prévus aux extrémités de chaque groupe. Les contacts base se trouvent au premier niveau de métal ainsi que les lignes BL—1 à BL—8.

Les zones émetteurs N+ 81 à 84 correspondant aux transistors T1—1, 1; T1—1, 3; T1—1, 4 et T1—1, 7 sont diffusées dans les régions 60—1 et 60—2 et un court-circuit est réalisé au deuxième niveau de métal par l'intermédiaire de trous de connexion 62—1 et 62—2 aux contacts de bases situés aux deux extrémités du groupe 61—1 et 61—2 constituant la ligne de mot L1—1. Cette structure est répétée pour toutes les lignes de l'ensemble.

Ainsi, tant dans le réseau de la figure 7 que dans le réseau de la figure 6, la densité est accrue par rapport à la densité que l'on peut obtenir dans des réseaux où tous les éléments sont isolés, mais les performances ne sont pas diminuées du fait des court-circuits qui permettent d'améliorer les caractéristiques des lignes, par rapport à celles obtenues dans le réseau de densité similaire décrit dans le brevet 71 16554 cité au début de la description.

Bien que l'on ait décrit dans ce qui précède et re présenté sur les dessins les caractéristiques essentielles de l'invention appliquées à plusieurs modes de réalisation préférés de celle-ci, il est évident que l'homme de l'art peut y apporter toutes modifications de forme ou de détail qu'il juge utiles, sans pour autant sortir du cadre de ladite invention.

## Revendications

1. Réseau matriciel intégré dans lequel des positions sont définies aux intersections de lignes parallèles d'une première série (BL—1 à BL—8) définissant des colonnes (ou rangées) de positions avec des lignes parallèles d'une seconde série (L1—1 à LP—8) définissant des rangées (ou colonnes) de positions, lesdites positions pouvant être ou non occupées par des éléments semi-conducteurs (Si, j), présentant au moins une première électrode connectée à une ligne de la première série et une seconde électrode connectée à une ligne de la seconde série, le réseau étant du type dans lequel les premières électrodes des éléments dans chaque colonne (ou rangée) sont définies dans une zone semi-conductrice, les secondes électrodes n'étant présentes qu'aux positions occupées par un élément semi-conducteur, ledit réseau étant caractérisé en ce que: ladite zone semi-conductrice dans chaque colonne (ou rangée) n'est présente que dans une pluralité de régions disjointes parmi lesquelles deux régions adjacentes successives sont associées à un groupe distinct de 2k positions successives d'éléments semi-conducteurs, la première région (20—1) s'étendant depuis une extrémité du groupe jusqu'à la position occupée par un élément semi-conducteur le plus proche du point milieu du groupe et l'autre région (20—2) s'étendant depuis l'autre extrémité du groupe jusqu'à la position occupée par un élément semi-conducteur le plus proche du point milieu du groupe, des moyens de liaison (22—1, 23—1, 22—2, 23—2, 24) sont prévus dans chaque groupe pour réaliser la liaison électrique entre les deux régions de zones semi-conductrices, lesdits moyens de liaison comprenant des moyens de contact avec la zone semi-conductrice, situés aux extrémités du groupe et un court-circuit entre lesdits moyens de contact.

2. Réseau selon la revendication 1 caractérisé en ce que chaque moyen de contact comprend un contact (22—1, 22—2) avec la zone semi-conductrice situé au premier niveau de métallisation et un trou de connexion (23—1, 23—2) entre le premier niveau de métallisation et un second niveau de métallisation séparé du premier par une couche de matériau isolant (34), et le court-circuit (24) est réalisé au second niveau de métallisation entre les deux contacts aux extrémités de chaque groupe par l'intermédiaire des trous de connexion.

3. Réseau selon la revendication 1 ou 2 caractérisé en ce que les éléments semi-conducteurs sont des diodes de Schottky (Si, j) dans lesquelles les premières électrodes sont définies dans les zones semi-conductrices et les secondes électrodes présentes ou non sont les anodes qui sont connectées aux lignes de la seconde série situées au premier niveau de métallisation.

4. Réseau selon la revendication 3 intégré dans un substrat de type P, caractérisé en ce que dans chaque groupe les régions de zones semi-conductrices sont constituées par des couches semi-conductrices de conductivité de type N (20—1, 20—2) avec des couches sous-jacentes de sous-collecteurs de type N+ (21—1, 21—2), les deux régions étant séparées par une zone d'isolation de type P+ (30).

5. Réseau selon la revendication 4 caractérisé en ce que les colonnes (ou rangées) de diodes sont isolées les unes des autres par des parois d'isolation (42) de type P+.

6. Réseau selon la revendication 1 ou 2 caractérisé en ce que les éléments semi-conducteurs sont des transistors (T1—1, 5) dans lesquels les premières électrodes sont les bases définies dans les régions de zones semi-conductrices (60—1, 60—2), les secondes électrodes présentes ou non sont les émetteurs qui sont connectés aux lignes de la seconde série situées au premier niveau de métallisation, les collecteurs desdits transistors étant connectés à une tension de polarisation.

7. Réseau selon la revendication 6 caractérisé en ce que les transistors sont du type NPN, intégrés dans un substrat de type P.

8. Réseau selon la revendication 7 caractérisé en ce que dans chaque groupe les deux régions de zone semi-conductrice sont de conductivité de type P, dans lesquelles sont diffusées les zones d'émetteurs de type N+ dans les positions occupées par un élément semi-conducteur auxquelles viennent faire contact les lignes de la seconde série.

9. Réseau selon l'une quelconque des revendications précédentes caractérisé en ce qu'il constitue une mémoire morte, la présence d'un élément semi-conducteur dans une position représentant une information binaire d'un type et l'absence d'un élément semi-conducteur dans une position représentant l'information binaire de l'autre type.

## Patentansprüche

1. Integrierte Halbleiterelementenmatrix, deren Stellen an den Kreuzungspunkten zwischen den parallelen Linien einer ersten Serie (BL—1 bis BL—8), die Spalten (oder Zeilen) von Stellen definieren, und den parallelen Linien einer zweiten Serie (L1—1 bis L1—8), die Zeilen (oder Spalten) definieren, vorgesehen sind, wo die Stellen Halbleiterelemente (Si, j) oder nicht enthalten, die mindestens eine erste mit einer Linie der ersten Serie verbundene Elektrode und eine zweite mit einer Linie der zweiten Serie verbundene Elektrode haben, derart, daß die ersten zu den Halbleiterelementen jeder Spalte (oder Zeile) gehörigen Elektroden in einer Halbleiterzone hergestellt sind, während die zweiten Elektroden sich nur in den ein Halbleiterelement enthaltenden Stellen befinden, dadurch gekennzeichnet, daß die genannte Halbleiterzone jeder Spalte (oder Zeile) nur in einer Vielzahl von Teilbereichen vorliegt, unter denen zwei benachbarte aufeinanderfolgende Teilbereiche mit einer gesonderten Gruppe von 2k aufeinanderfolgenden Stellen von Halbleiterelementen verbunden sind, wobei sich der erste Bereich (20—1) vom einen Ende der Gruppe bis zu der das am nächsten im Verhältnis zu der mittleren Stelle der genannten Gruppe vorliegende Halbleiterelement enthaltenden Stelle, und sich der zweite Bereich (20—2) vom anderen Ende der Gruppe bis zu der das am nächsten im Verhältnis zu der mittleren Stelle der genannten Gruppe vorliegende Halbleiterelement enthaltenden Stelle erstreckt, und daß ferner Verbindungsmittel (22—1, 23—1, 22—2, 23—2, 24) in jeder Gruppe vorgesehen sind, um die elektrische Verbindung zwischen den zwei Teilbereichen der Halbleiterzonen zu versorgen, wobei die Verbindungsmittel an den beiden Enden der Gruppe angeordnete Mittel zur Herstellung eines Kontaktes mit der Halbleiterzone und eine Kurzschlußvorrichtung zwischen den Kontaktmitteln aufweisen.

2. Matrix nach Anspruch 1, dadurch gekennzeichnet, daß jedes Kontaktmittel einen eigentlichen auf der ersten Metallisierungsebene angeordneten Kontakt (22—1, 22—2) mit der Halbleiterzone sowie eine Durchgangsverbindung (23—1, 23—2) zwischen der ersten Metallisierungsebene und der zweiten Metallisierungsebene, welche von der ersten durch eine aus einem Isolationsmaterial bestehende Schicht (34) getrennt ist, aufweist, und daß die Kurzschlußvorrichtung (24) auf die zweite Metallisierungsebene zwischen den zwei an beiden Enden der Gruppe vorliegenden Anschlüssen mittels Durchgangsverbindungen ausgeführt ist.

3. Matrix nach Anspruch 1 oder 2, dadurch gekennzeichnet, daß die Halbleiterelemente Schottky-Dioden (Si, j) sind, bei denen die ersten Elektroden in den Halbleiterzonen definiert sind, und die zweiten vorliegenden oder nicht vorliegenden Elektroden die Anoden sind, die mit den auf der ersten Metallisierungsebene angeordneten Linien der zweiten Serie verbunden sind.

4. In einem P-leitenden Substrat integrierte Matrix nach Anspruch 3, dadurch gekennzeichnet, daß in jeder Gruppe die Teilbereiche der Halbleiterzonen aus N-leitenden halbleitenden Schichten (20—1, 20—2) mit N+-leitenden Subkollektor-Unterschichten (21—1, 21—2) bestehen, wobei beide Teilbereiche durch eine P+-leitende Isolierungszone (30) voneinander getrennt sind.

5. Matrix nach Anspruch 4, dadurch gekennzeichnet, daß die Spalten (oder Zeilen) von Dioden durch P+-leitende Isolierungswände (42) voneinander getrennt sind.

6. Matrix nach Anspruch 1 oder 2, dadurch gekennzeichnet, daß die Halbleiterelemente Transistoren (T1—1, 5) sind, bei denen die ersten Elektroden in den Teilbereichen der Halbleiterzonen (60—1, 60—2) die Basen sind, die zweiten vorliegenden oder nicht vorliegenden Elektroden die Emitter sind, welche mit den auf der ersten Metallisierungsebene angeordneten Linien der zweiten Serie verbunden sind, und bei denen die Kollektoren der Transistoren mit der Vorspannung verbunden sind.

7. Matrix nach Anspruch 6, dadurch gekennzeichnet, daß die Transistoren NPN-leitend und in dem P-leitenden Substrat integriert sind.

8. Matrix nach Anspruch 7, dadurch gekennzeichnet, daß in jeder Gruppe die zwei Teilbereiche der Halbleiterzone P-leitend sind, in denen die N-leitenden Emitterzonen in denjenigen ein Halbleiterelement enthaltenden Stellen diffundiert sind, mit denen die Linien der zweiten Serie Herstellung eines Kontaktes ermöglichen.

9. Matrix nach einem der vorhergehenden Ansprüche, dadurch gekennzeichnet, daß sie einen Festwertspeicher bildet, bei dem ein vorliegendes Halbleiterelement in einer Stelle eine binäre Information eines ersten Typs und ein nicht vorliegendes Halbleiterelement in einer Stelle eine binäre Information eines zweiten Typs darstellen.

## Claims

1. Integrated matrix array the points of which are defined by the intersections of the parallel lines of a first set (BL—1 to BL—8) which define columns (or rows) of points with the parallel lines of a second set (L1—1 to L1—8) which define rows (or columns) of points, said points being or not provided with semiconducting elements (Si, j) with at least, a first electrode connected to a line of the first set and a second electrode connected to a line of the second set, the array being of the type in which the first electrodes of the elements in each column (or row) are defined in a semiconducting region, the second electrodes being provided only in the positions provided with a semiconducting element, said array being characterized in that: the semiconducting region in each column (or row), is present only in a plurality of partitioned portions two of said, adjacent and successive portions, are associated to a separate group of 2k successive positions of semiconducting elements, the first portion (20—1) extending from one end of the group up to the position provided with the semiconducting element the closest to the middle point of the group and the second portion (20—2) extending from the other end of the group up to the position provided with the semiconducting element the closest to the middle point of the group, connecting means (22—1, 23—1, 22—2, 23—2, 24) are provided in each group to ensure the electrical connection between the two portions of the semiconducting region, said connecting means including contact means with the semiconducting region, which are located at both ends of the group as well as a short circuit between said contacts.

2. Array according to claim 1 characterized in that each connecting means includes a contact (22—1, 22—2) with the semiconducting region located at the first metal level and a via (23—1, 23—2) between the first metal level and a second metal level isolated from the first one by a layer of isolating material (34), the short circuit (24) is provided at the second metal level between the two contacts at the ends of each group through the vias.

3. Array according to claim 1 or 2 characterized in that the semiconducting elements are Schottky diodes (Si, j) in which the first electrodes are defined in the semiconducting regions and the second electrodes which may be present or not, make up the anodes which are connected to the lines of the second set located at the first metal level.

4. Array according to claim 3, integrated in a P type substrate characterized in that, in each group, the portions of the semiconducting regions are in semiconducting layers of conductivity of the N type (20—1, 20—2) with subcollector underlying layers of the N+ type (21—1, 21—2), both portions being isolated by an isolation region of the P+ type (30).

5. Device according to claim 4 characterized in that the columns (or rows) of diodes are isolated from each other by isolation walls (42) of the P+ type.

6. Array according to claim 1 or 2 characterized in that the semiconducting elements are transistors (T1—1, 5) in which the first electrodes are the bases defined in the portions of the semiconducting regions (60—1, 60—2), the second electrodes which may be present or not, are the emitters which are connected to the lines of the second set located at the first metal level, the collectors of said transistors being connected to a biasing voltage supply.

7. Array according to claim 6 characterized in that the transistors are the NPN type and integrated in a substrate of the P type.

8. Array according to claim 7 characterized in that in each group, both portions of the semiconducting region have a conductivity of the P type, the emitter regions of the N+ type being diffused into the points of said portions provided with a semiconducting element and connected to the lines of the second set.

9. Array according to any one of the preceding claims characterized in that it forms a read only memory, the presence of a semiconducting element in a point representing a binary information of a first type while the absence of a semiconducting element in a point represents the binary information of a second type.

# FIG.1

# FIG. 2

22-1

23-1
20-1
21-1
L1-1

ANODE
S1-1,1
L1-2

L1-3

24

L1-4

L1-5

L1-6

L1-7

L1-8

20-2

21-2

22-2

23-2

A'

BL1          BL2

FIG. 3

VIA
23-2
24
22-2  34
CONTACT
CATHODES
ANODE
S1-7,1
23-1
31
L1-7
L1-2  L1-1
22-1
32  N+
N+
N+
21-2
ISOLATION P+
SUBSTRAT P
20-2
20-1
21-1  33
30

FIG. 4

24
ANODE
S1-7,1
34
L1-7
41  P+
20-2  ISO
P+
ISO
42
P+
ISO
43
21-2
SUBSTRAT P
30

0 030 280

# FIG. 5

A1  A2  A3  A4  A5  A6  A7  A8

BL1  BL2  BL3  BL4  BL5  BL6  BL7  BL8

V

L1-1

T1-1,5

L1-2

# FIG. 6

CONTACT
EMETTEUR
T1-1,1

BL1  BL2  BL3  BL4  BL5  BL6  BL7  BL8

62-2    61-1    60-1    60-2    61-2
                                62-2

D                                       D'

L1-1

L1-2

63-1                            63-2

C'

CONTACT EMETTEUR
T1-2,2

# FIG. 7

# FIG. 8